(19) Europäisches Patentamt
European Patent Office
Office européen des brevets

(11) EP 3 067 949 A1

(12) **EUROPEAN PATENT APPLICATION**

(43) Date of publication:
**14.09.2016 Bulletin 2016/37**

(21) Application number: **15158258.2**

(22) Date of filing: **09.03.2015**

(51) Int Cl.:
***H01L 51/42*** *(2006.01)* ***H01L 31/0224*** *(2006.01)*
***H01L 51/46*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicants:
- **Heraeus Deutschland GmbH & Co. KG**
  **63450 Hanau (DE)**
- **Institut für Solarenergieforschung GmbH**
  **31860 Emmerthal (DE)**

(72) Inventors:
- **Schmidt, Jan**
  **31789 Hameln (DE)**
- **Zielke, Dimitri**
  **30459 Hannover (DE)**
- **Elschner, Andreas**
  **45468 Mülheim (DE)**
- **Lövenich, Wilfried**
  **51469 Bergisch Gladbach (DE)**
- **Hörteis, Matthias**
  **63454 Hanau (DE)**
- **Scheel, Arnulf**
  **50735 Köln (DE)**

(74) Representative: **Herzog, Fiesser & Partner Patentanwälte PartG mbB**
**Immermannstrasse 40**
**40210 Düsseldorf (DE)**

(54) **Conductive polymer/si interfaces at the back side of solar cells**

(57) The present invention relates to a solar cell (1) comprising a substrate (2) of p-type silicon or n-type silicon, wherein the substrate (2) comprises
- a front side (2a) the surface of which is at least partially covered with at least one passivation layer (3) and
- a back side (2b),

wherein the back side (2b) of the substrate (2) is at least partially covered with a conductive polymer layer (4) and wherein at least one of the following conditions a) and b) is fulfilled:
a) the conductive polymer layer (4) is at least partially in direct contact with the surface of the p-type or n-type silicon;
b) the conductive polymer layer (4) comprises a cationic conductive polymer and a polymeric anion in a weight ratio cationic conductive polymer : polymeric anion of greater than 0.4.

The present invention also relates to a process for the preparation of a solar cell, to a solar cell obtainable by this process and to a solar module.

Fig. 1

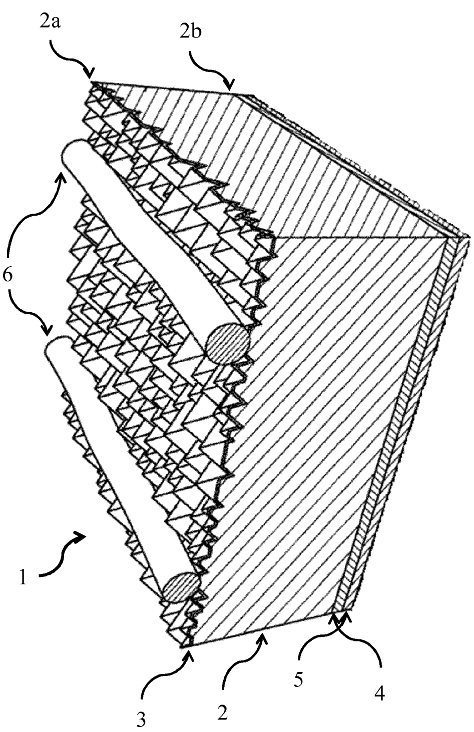


EP 3 067 949 A1

## Description

FIELD OF THE INVENTION

The present invention relates to a solar cell, a process for the preparation of a solar cell, to a solar cell obtainable by this process and to a solar module.

BACKGROUND OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs. When light hits a solar cell, a fraction of the incident light is reflected by the surface and the remainder transmitted into the solar cell. The transmitted photons are absorbed by the solar cell, which is usually made of a semiconducting material, such as silicon which is often doped appropriately. The absorbed photon energy excites electrons of the semiconducting material, generating electron-hole pairs. These electron-hole pairs are then separated by p-n junctions and collected by conductive electrodes on the solar cell surfaces.

Solar cells are very commonly based on silicon, often in the form of a Si wafer. Here, a p-n junction is commonly prepared either by providing an n-type doped Si substrate and applying a p-type doped layer to one face or by providing a p-type doped Si substrate and applying an n-type doped layer to one face to give in both cases a so called p-n junction. Both n-type and p-type solar cells are possible and have been exploited industrially.

In order to achieve high efficiencies in solar cells it is necessary to minimize recombination losses in the solar cell. Here a distinction must be made between (i) recombination in the crystalline silicon wafer, (ii) the recombination at the non-metallized surfaces of the solar cell which can be passivated with dielectric layers such as $SiO_2$, $SiN_X$ or $Al_2O_3$, and (iii) the recombination at the metal-semiconductor junctions of the solar cell.

The high recombination at the metallized surface of a Si solar cell will more and more dominate the total loss of recombination as the passivation of not metallized areas with dielectric layers such as $SiO_2$, $SiN_x$ or $Al_2O_3$ increasingly finds its way into the production of solar cells. In order to approach the technologically feasible limit of the solar cell efficiency (about 25 %) it is essential to effectively reduce the recombination at the metal/semiconductor interfaces of the solar cell while avoiding that the contact resistance is not increased to an inacceptable extend.

In the last few years heterojunctions with amorphous silicon (a-Si) have proven to be an effective way of reducing the recombination at the metal/semiconductor interfaces. The deposition of the a-Si layer is usually effected by means of plasma enhanced chemical vapor deposition ("*Plasma Enhanced Chemical Vapor Deposition*", PECVD) using silane, hydrogen and diborane for the deposition of a p-type layer [a-Si (p)] or phosphine for the deposition of an n-type layer [a-Si (n)]. To achieve the required throughput by means of the a-Si/c-Si-heterojunction technology relatively thin a-Si layers are deposited by means of PECVD, resulting in an insufficient lateral conductivity. In order to reduce the layer resistance a transparent conductive layer such as an indium tin oxide (ITO) layer, is deposited on the a-Si layer. In view of the high efficiency potential of a-Si/c-Si-heterojunctions this solar cell technology is considered by many experts to be a realistic option for the next generation of industrial solar cells with efficiencies above 23 %.

However, the disadvantage in this approach has to be seen in the fact that, as an ITO-layer has to be deposited to reduce the sheet resistance, the material costs are quite high and the use of rare metals such as indium in solar cells is generally problematic, especially in the long term. Furthermore, gases such as phosphine or diborane are used for the doping of the a-Si layers and these gases are known and feared as being extremely dangerous poison gases.

A further approach for reducing the recombination at the metal/semiconductor interfaces of the solar cell is the use of Si/organic heterojunctions. Organic-silicon hybrid solar cells composed of an n-type crystalline silicon base and an organic poly(3,4-ethylenedioxythiophene) : poly(styrenesulfonate) (PEDOT : PSS) hole-conducting emitter layer provide a unique possibility to combine the high energy conversion efficiencies of crystalline silicon solar cells with the potentially low fabrication cost of organic solar cells. Schmidt et al. ("Organic-silicon heterojunction solar cells: Open-circuit voltage potential and stability"; Appl. Phys. Lett. 103, 183901 (2013)) have characterized the electronic properties of crystalline silicon (c-Si)/(PEDOT : PSS) junctions by means of contactless carrier lifetime measurements on silicon wafers and fabricated a solar cell in which the (c-Si)/(PEDOT : PSS) junction was localized at the textured front side.

However, the approach disclosed by Schmidt *et al.* (i. e. the application of PEDOT : PSS on the front side of the silicon solar cell) is characterized by several disadvantages. First of all, the PEDOT : PSS-layer on the solar cell front side is characterized by a strong parasitic absorption, which limits the short-circuit current of this cell type. Moreover, the refractive index of the PEDOT : PSS-layer is not optimal so that the PEDOT : PSS layer cannot serve as a good anti-reflective layer (compared to, for example, anti-reflective layers based on $SiN_x$). Also, the contact resistance of the PEDOT : PSS layer is comparatively high and the stability of the solar cell disclosed by Schmidt *et al.* in humid air and towards UV-radiation is insufficient.

## SUMMARY OF THE INVENTION

The present invention is generally based on the object of overcoming at least one of the problems encountered in the state of the art in relation to solar cells.

More specifically, the present invention is further based on the object of providing solar cells with high efficiencies in which losses through recombination at the metal/semiconductor interfaces are reduced and which can be produced in a simple manner. Compared to solar cells known in the prior art that have been prepared for that purpose the solar cells according to the present invention should be characterized by an improved stability when being stored in a humid atmosphere and/or an improved stability towards UV-radiation.

A further object of the present invention is to provide processes for preparing solar cells, particularly n-type silicon solar cells, being characterized by the above mentioned properties, wherein the use of dangerous poison gases can be avoided and by means of which the solar cells can be produced in a simple and economic manner.

A contribution to achieving at least one of the above described objects is made by the subject matter of the category forming claims of the present invention. A further contribution is made by the subject matter of the dependent claims which represent specific embodiments of the invention.

## EMBODIMENTS

|1| A solar cell comprising a substrate of p-type silicon or n-type silicon, wherein the substrate comprises

- a front side the surface of which is at least partially covered with at least one passivation layer and
- a back side,

wherein the back side of the substrate is at least partially covered with a conductive polymer layer and wherein at least one of the following conditions a) and b) is fulfilled:

a) the conductive polymer layer is at least partially in direct contact with the surface of the p-type or n-type silicon;
b) the conductive polymer layer comprises a cationic conductive polymer and a polymeric anion in a weight ratio cationic conductive polymer : polymeric anion of greater than 0.4.

|2| The solar cell according to embodiment |1|, wherein condition a) is fulfilled.

|3| The solar cell according to embodiment |1|, wherein condition b) is fulfilled.

|4| The solar cell according to embodiment |1|, wherein conditions a) and b) are fulfilled.

|5| The solar cell according to anyone of embodiments |1| to |4|, wherein the substrate is of p-type silicon.

|6| The solar cell according to anyone of embodiments |1| to |4|, wherein the substrate is of n-type silicon.

|7| The solar cell according to embodiment |6|, wherein the substrate is based on n-type monocrystalline silicon (c-Si).

|8| The solar cell according to anyone of embodiments |1| to |7|, wherein the at least one passivation layer is selected from the group consisting of a silicon nitride layer ($SiN_x$), a silicon oxide layer ($SiO_x$), a silicon carbide layer (SiC), a titanium oxide layer ($Ti\text{-}O_x$), an aluminium oxide layer ($AlO_x$), a layer of amorphous silicon (a-Si) or a layer stack comprising of an intrinsic undoped amorphous silicon layer (a-Si (i)) and Si nor p-doped amorphous silicon layer (a-Si (n)) or a combination of at least two of these layers.

|9| The solar cell according to anyone of embodiments |1| to |8|, wherein the surface on the front side of the substrate has a texture with maxima and minima.

|10| The solar cell according to anyone of embodiments |1| to |9|, wherein the solar cell comprises a first metal containing layer being in an electrically conductive contact with the front side of the substrate and a second metal containing layer being in an electrically conductive contact with the conductive polymer layer on the back side of the substrate.

|11| The solar cells according to embodiment |10|, wherein the substrate at the front side and beneath the at least one passivation layer comprises an n-doped front surface field ($n^+$-FSF) (2').

|12| The solar cells according to embodiment |10|, wherein the passivation layer is a layer of n-doped amorphous silicon (a-Si (n)) or a layer stack comprising an intrinsic undoped amorphous silicon layer (a-Si (i)) and Si n-doped amorphous silicon layer (a-Si (n)) and wherein the passivation layer is covered with a layer of a transparent conductive coating.

|13| The solar cell according to anyone of embodiment |10| to |12|, wherein the first metal containing layer being in an electrically conductive contact with the front side of the substrate is applied in the form of a metal grid or in the form of a pattern comprising at least one metal busbar and metal fingers.

|14| The solar cell according to anyone of of embodiments |1| to |9|, wherein the solar cell comprises a first metal containing layer being in an electrically conductive contact with the back side of the substrate and a second metal containing layer being in an electrically conductive contact with the conductive polymer layer on the back side of the substrate.

|15| The solar cell according to anyone of embodiments |1| to |14|, wherein the conductive polymer layer comprises a cationic polythiophene as the cationic conductive polymer and a polymeric sulfonic acid or a polymeric carboxylic acid as the polymeric anion.

|16| The solar cell according to embodiment |15|, wherein the polymeric anion is a polymeric sulfonic acid.

|17| The solar cell according to embodiment |16|, wherein the polymeric sulfonic acid is polystyrene sulphonic acid (PSS).

|18| The solar cell according to anyone of embodiments |15| to |17|, wherein in the conductive polymer layer the cationic polythiophene and the polymeric anion are present in the form of a polythiophene : polymeric anion-complex.

|19| The solar cell according to embodiment |18|, wherein in the conductive polymer layer the cationic polythiophene and the polymeric anion are present in the form of a PEDOT : PSS-complex.

|20| The solar cell according to anyone of embodiments |1| to |19|, wherein in the conductive polymer layer the weight ratio cationic conductive polymer : polymeric anion is greater than 0.5.

|21| The solar cell according to embodiment |20|, wherein in the conductive polymer layer the weight ratio cationic conductive polymer : polymeric anion is greater than 0.6.

|22| The solar cell according to embodiment |21|, wherein in the conductive polymer layer the weight ratio cationic conductive polymer : polymeric anion is greater than 0.65.

|23| A process for the preparation of a solar cell comprising the process steps:

I) providing a substrate of p-type silicon or n-type silicon, wherein the substrate comprises

- a front side
  and
- a back side;

II) treatment of the back side with an etching agent;
III) covering at least a part of the treated surface on the back side of the substrate with a layer of a conductive polymer, wherein at least one of the following conditions A) and B) is fulfilled:

A) in process step III) the treated surface on the back side of the substrate is brought into contact with the layer of a conductive polymer in such a way that the conductive polymer layer is at least partially in direct contact with the surface of the p-type or n-type silicon;
B) the conductive polymer layer comprises a cationic conductive polymer and a polymeric anion in a weight ratio cationic conductive polymer : polymeric anion of greater than 0.4;

IV) optionally covering at least a part of the surface of the conductive polymer layer with a metal containing layer.

|24| The process according to embodiment |23|, wherein condition A) is fulfilled.

|25| The process according to embodiment |23|, wherein condition B) is fulfilled.

|26| The process according to embodiment |23|, wherein conditions A) and B) are fulfilled.

|27| The process according to anyone of embodiments |23| to |26|, wherein the substrate is of p-type silicon.

|28| The process according to anyone of embodiments |23| to |26|, wherein the substrate is of n-type silicon.

|29| The process according to embodiment |28|, wherein the substrate is based on n-type monocrystalline silicon (c-Si).

|30| The process according to anyone of embodiments |23| to |29|, wherein the etching agent is an aqueous solution of at least one mineral acid, preferably an aqueous solution of HF, or an aqueous solution of a mixture of HF and at least one further mineral acid selected from the group consisting of $H_2SO_4$, $H_3PO_4$, HBr, HI, $HClO_4$ and $HIO_4$.

|31| The process according to embodiment |30|, wherein the etching solution is an aqueous hydrofluoric acid solution having a concentration the range from 0.1 to 5 wt.-%.

|32| The process according to anyone of embodiments |23| to |31|, wherein the conductive polymer layer is formed by applying a liquid composition comprising the cationic conductive polymer, the polymeric anion and a solvent onto the back side and by subsequently removing at least a part of the solvent.

|33| The process according to anyone of embodiments |23| to |32|, wherein the liquid composition comprises a cationic polythiophene as the cationic conductive polymer and a polymeric sulfonic acid or a polymeric carboxylic acid as the polymeric anion.

|34| The process according to embodiment |33|, wherein the polymeric anion is a polymeric sulfonic acid.

|35| The process solar according to embodiment |34|, wherein the polymeric sulfonic acid is polystyrene sulphonic acid (PSS).

|36| The process according to anyone of embodiments |32| to |35|, wherein in the liquid composition the cationic polythiophene and the polymeric anion are present in the form of a polythiophene : polymeric anion-complex.

|37| The process according to embodiment |36|, wherein in the liquid composition the cationic polythiophene and the polymeric anion are present in the form of a PEDOT : PSS-complex.

|38| The process according to anyone of embodiments |23| to |37|, wherein in the liquid composition the weight ratio cationic conductive polymer : polymeric anion is greater than 0.5.

|39| The process according to embodiment |38|, wherein in the conductive polymer layer the weight ratio cationic conductive polymer : polymeric anion is greater than 0.6.

|40| The process according to embodiment |39|, wherein in the liquid composition the weight ratio cationic conductive polymer : polymeric anion is greater than 0.65.

|41| The process according to anyone of embodiments |23| to |40|, wherein the substrate (2) is based on n-type monocrystalline silicon (c-Si).

|42| The process according to anyone of embodiments |23| to |41|, wherein the surface on the front side of the substrate is at least partially covered with at least one passivation layer selected from the group consisting of a silicon nitride layer ($SiN_x$), a silicon oxide layer ($SiO_x$), a silicon carbide layer (SiC), a titanium oxide layer ($TiO_x$), an aluminium oxide layer ($AlO_x$), a layer of amorphous silicon (a-Si) or a layer stack comprising of an intrinsic undoped amorphous silicon layer (a-Si (i)) and Si n- or p-doped amorphous silicon layer (a-Si (n)) or a combination of at least

two of these layers.

|43| The process according to anyone of embodiments |23| to |42|, wherein the surface on the front side of the substrate has a texture with maxima and minima.

|44| Solar cell, obtainable by the process according to anyone of embodiments |23| to |43|.

|45| A solar module, comprising at least one solar cell according to anyone of embodiments |1| to |22| or |44| and at least one further solar cell.

DETAILED DESCRIPTION OF THE INVENTION

A contribution to achieving at least one of the above described objects is made by a solar cell comprising a substrate of p-type silicon or n-type silicon, wherein the substrate comprises

- a front side the surface of which is at least partially covered with at least one passivation layer and

- a back side,

wherein the back side of the substrate is at least partially covered with a conductive polymer layer and wherein at least one of the following conditions a) and b) is fulfilled:

a) the conductive polymer layer is at least partially in direct contact with the surface of the p-type or n-type silicon;

b) the conductive polymer layer comprises a cationic conductive polymer and a polymeric anion in a weight ratio cationic conductive polymer : polymeric anion of greater than 0.4, preferably greater than 0.5, more preferably greater than 0.6 and even more preferably greater than 0.65.

The solar cell according to the present invention is characterized by the fact that a conductive polymer layer, such as e. g. a polythiophene layer, a polypyrrole layer or a polyaniline layer, is deposited on the solar cell back side (i. e. the side of the solar cell that is not exposed to the sun) as a hole-transporting layer. Since conductive polymer layer is localized at back side of the solar cell, there will be no more relevant parasitic absorption and the non-optimal antireflection properties are also irrelevant. In addition, the conductive polymer layer in combination with the metal layer that is deposited on the whole surface acts as a good mirror for the infrared light passing through the solar cell. It therefore contributes in many ways to an increase of the photocurrent. In addition, the conductive polymer layer can now be completely metallized which leads to a significantly reduced contact resistance between the conductive polymer layer and the metal layer. Compared to a solar cell in which the conductive polymer layer is applied on the surface of the front side of the silicon wafer (like the solar cell disclosed by Schmidt *et al.*) and in which only a small area (< 10 %) of the conductive polymer layer is metallized with a metal grid, the total contact resistance in the solar cell according to the present invention with a conductive polymer layer on the back side of the silicon wafer is reduced by an order of magnitude.

Another significant advantage of the solar cell structure according to the present invention is its increased stability. The conductive polymer/c-Si-heterojunction localized on the back side of the solar cell is not exposed to UV photons since these photons are absorbed in the silicon wafer, resulting in an increased UV stability of the solar cell. Moreover, since the conductive polymer layer is completely covered with the metallization layer, which at the same time also acts as an "encapsulation", the conductive polymer layer does not come into direct contact with ambient air. This in turn leads to an increased stability as the absorption of moisture by the conductive polymer layer is avoided.

The solar cell according to the present invention comprises a substrate of p-type silicon or n-type silicon.

Doped Si substrates are well known to the person skilled in the art. The doped Si substrate can be prepared in any way known to the person skilled in the art and which he considers to be suitable in the context of the invention. Preferred sources of Si substrates according to the invention are based on amorphous silicon (a-Si), monocrystalline silicon (c-Si), multicrystalline silicon (mc-Si), upgraded metallurgical silicon (umg-Si), thin-film crystalline silicon (thinner than 50 $\mu$m) or a combination of at least two of these materials, wherein monocrystalline silicon (c-Si) is the preferred substrate material. Particularly preferred materials are n-doped or p-doped monocrystalline silicon, wherein n-doped monocrystalline silicon is the most preferred material for the substrate. Doping to form the doped Si substrate can be carried out simultaneously by adding a dopant during the preparation of the Si substrate or can be carried out in a subsequent step. Doping subsequent to the preparation of the Si substrate can be carried out for example by gas diffusion epitaxy. Doped Si substrates are also readily commercially available. According to the invention it is one option for the

initial doping of the Si substrate to be carried out simultaneously to its formation by adding dopant to the Si mix.

It is known to the person skilled in the art that Si substrates can exhibit a number of shapes, surface textures and sizes. The shape can be one of a number of different shapes including cuboid, disc, wafer and irregular polyhedron amongst others. The preferred shape according to the present invention is wafer shaped where that wafer is a cuboid with two dimensions which are similar, preferably equal and a third dimension which is significantly less than the other two dimensions. Significantly less in this context is preferably at least a factor of about 100 smaller.

A variety of surface types are known to the person skilled in the art. According to the invention Si substrates with rough surfaces are preferred. One way to assess the roughness of the substrate is to evaluate the surface roughness parameter for a sub-surface of the substrate which is small in comparison to the total surface area of the substrate, preferably less than one hundredth of the total surface area, and which is essentially planar. The value of the surface roughness parameter is given by the ratio of the area of the subsurface to the area of a theoretical surface formed by projecting that subsurface onto the flat plane best fitted to the subsurface by minimising mean square displacement. A higher value of the surface roughness parameter indicates a rougher, more irregular surface and a lower value of the surface roughness parameter indicates a smoother, more even surface. According to the invention, the surface roughness of the Si substrate is preferably modified so as to produce an optimum balance between a number of factors including but not limited to light absorption and adhesion of fingers to the surface.

In this context it is preferred that the surface on the front side of the substrate (i. e. the side that is exposed to sun light) has a texture with maxima and minima. A particularly preferred texture has concave and convex patterns with a minute pyramid (i. e. square pyramid) shape. In a solar cell with such a texture at the front surface the light reflected from one spot impinges again to another spot on the surface of the crystalline solar cell by virtue of the textured surface, penetrating into the solar cell to be effectively absorbed in the solar cell. Although a portion of the impinging light that has not been fully absorbed, but arrives at the back face of the solar cell, is reflected back to the surface again, that portion of impinging light can be reflected again at the surface comprising steeply inclined pyramidal surfaces, thereby confining the light in the solar cell to improve absorption of light and to enhance power generation.

A textured structure including non-inverted pyramids can, for example, be formed by immersing the exposed face of a silicon wafer into a mixed solution prepared by adding 5 to 30% by volume of isopropyl alcohol into an aqueous solution of an alkaline, for example sodium hydroxide (NaOH) or potassium hydroxide (KOH), which may also include some added silicon. Etching in this mixed solution is performed at a temperature of from 70°C to 95°C. Further details for preparing textured structure on the surface of a Si wafer are, for example, disclosed in US 2004/0259335 A1, US 2013/0025663 A1 or WO 2012/025511 A1.

The surface of the front side of the substrate, preferably the surface of the front side of the n-type monocrystalline silicon waver, is at least partially covered with at least one passivation layer. Thorough passivation of the surface of a solar cell greatly improves the efficiency of the solar cell by reducing surface recombination. As used herein, "passivation" is defined as the chemical termination of dangling bonds present on the surface of a silicon lattice. Any passivation layer which is known to the person skilled in the art and which he considers to be suitable in the context of the invention can be employed. Preferred passivation layers according to the invention are silicon nitride layers, silicon oxide layers ($SiO_x$), in particular a $SiO_2$ layer, silicon carbide layers (SiC), titanium oxide layers ($TiO_x$), in particular a $TiO_2$ layer, aluminium oxide layers ($AlO_x$), in particular a $Al_2O_3$ layer, a layer of amorphous silicon (a-Si), in particular a layer of n-doped amorphous silicon (a-Si (n)) or a layer stack comprising of an intrinsic undoped amorphous silicon layer (a-Si (i)) and Si n- or p-doped amorphous silicon layer (a-Si (n)), in particular a double layer stack consisting of an a-Si0 (i)-layer and an a-Si (n)-layer, or a combination of at least two of these layers, wherein a $SiN_x$ layer is most preferred. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO). According to the invention, it is preferred for the passivation layer to have a thickness in a range from about 0.1 nm to about 1 $\mu$m, more preferably in a range from about 5 nm to about 500 nm and most preferably in a range from about 10 nm to about 250 nm.

Furthermore, the solar cell according to the present invention may further comprise an anti-reflection coating that is applied onto the passivation layer. Preferred anti-reflection coatings according to the invention are those which decrease the proportion of incident light reflected by the front face and increase the proportion of incident light crossing the front face to be absorbed by the wafer. All anti-reflection coatings known to the person skilled in the art and which he considers to be suitable in the context of the invention can be employed. Preferred anti-reflection coatings according to the present invention are those layers which have already been mentioned above as preferred passivation layers.

The thickness of anti-reflection coatings is suited to the wavelength of the appropriate light. According to the invention it is preferred for anti-reflection coatings to have a thickness in a range from about 20 to about 300 nm, more preferably in a range from about 40 to about 200 nm and most preferably in a range from about 60 to about 150 nm.

A single layer can serve as both, i.e. as an anti-reflection layer and as a passivation layer. In one embodiment of the solar cell according to the present invention, one or more layers which act as anti-reflection layer and/or passivation

layer are present at the front side of the substrate. For example, the passivation layer can be a dielectric double layer comprising an aluminium oxide containing layer, preferably an $Al_2O_3$ layer, or a silicon oxide containing layer, preferably a $SiO_2$ layer, and a further layer covering the aluminium oxide or the silicon oxide containing layer, wherein the further layer is selected from the group consisting of a silicon nitride layer, in particular a $Si_3N_4$-layer, a silicon oxide layer, a silicon carbide layer or a combination of at least two of these layers, preferably a silicon nitride layer.

The application of the above mentioned layers can be performed by means of PECVD (plasma enhanced chemical vapor deposition), APCVD (atmospheric pressure chemical vapor deposition) or atomic layer deposition (ALD). The deposition of an n-doped a-Si passivation layer can be effected by means of PECVD using silane, hydrogen and phosphine, as it is, for example, disclosed in US 2007/0209699 A1.

The solar cell according to the present invention is characterized in that the back side of the substrate is at least partially covered with a conductive polymer layer and wherein at least one of the following conditions a) and b) is fulfilled:

a) the conductive polymer layer is at least partially in direct contact with the surface of the p-type or n-type silicon;

b) the conductive polymer layer comprises a cationic conductive polymer and a polymeric anion in a weight ratio cationic conductive polymer : polymeric anion of greater than 0.4, preferably greater than 0.5, more preferably greater than 0.6 and even more preferably greater than 0.65.

According to a first particular embodiment of the solar cell according to the present invention condition a) is fulfilled. According to a second particular embodiment of the solar cell according to the present invention condition b) is fulfilled. According to a third particular embodiment of the solar cell according to the present invention conditions a) and b) are fulfilled.

According to condition a) the conductive polymer layer is at least partially in direct contact with the surface of the p-type or n-type silicon. The expression "*the conductive polymer layer is ...in direct contact with the surface of the p-type or n-type silicon*" preferably is understood in such a way that the components of the conductive polymer layer (i. e. the conductive polymer, in particular the complex of the conductive polymer and the polymeric anion) are in direct contact with the p-type or n-type silicon. In these areas of direct contact there is no further layer, in particular no passivation layer based on $SiO_x$ arranged between the p-type or n-type silicon and the components of the conductive polymer layer. Such a direct contact can be achieved by applying a liquid composition comprising a conductive polymer and a solvent to the back side of the substrate under a condition in which at least in a part of the surface on the back side of the substrate the p-type or n-type silicon is freely accessible. This can, for example, be accomplished by treating this surface with an etching solution before applying the conductive polymer layer, as described in detail later.

According to one embodiment of the solar cell according to the present invention at least 5 %, preferably at least 25 %, more preferably at least 50 %, even more preferably at least 75 % and most preferably at least 95 % of the surface of the p-type or n-type silicon on the back side of the substrate are in direct contact with the conductive polymer layer. According to a particularly preferred embodiment the complete surface of the p-type or n-type silicon on the back side of the substrate is in direct contact with the conductive polymer layer.

According to another embodiment of the solar cell according to the present invention in up to 95 %, preferably in up to 75 %, more preferably in up to 50 %, even more preferably in up to 25 % and most preferably in up to 5 % of the surface on the back side of the substrate the p-type or n-type silicon is not in direct contact with the conductive polymer layer. In these areas it is particularly preferred that a thin passivation layer, preferably a passivation layer based on $SiO_x$, is arranged between the p-type or n-type silicon and the conductive polymer layer. The thickness of the passivation layer, preferably of the $SiO_x$-layer, is preferably in the range from 0.2 nm to 1.0 nm. In the case of a $SiO_2$-layer the thickness of the passivation layer in these areas is preferably within about one or two monolayers of silicon dioxide. The thickness of such ultrathin passivation layers can, for example, be determined by high-resolution electron microscopy (HREM).

A surface of a substrate, preferably a surface of a substrate of p-type silicon or n-type silicon in which at least a part of the surface of the p-type or n-type silicon on the back side of the substrate is freely accessible and in which optionally a further part of the surface of the p-type or n-type silicon on the back side of the substrate is covered by $SiO_x$ as described above can, for example, be obtained by treating the back side of the substrate with an etching agent in order to remove any passivation layers that may be present on the back side of the substrate and that either

- may have been applied intentionally on the back side of the substrate (for example to protect the back side in previous fabrications steps or as a result of the formation of a passivation layer on the front side) or

- may have been formed while storing the substrate at ambient air (which may lead to the formation of a $SiO_x$-based passivation layer).

A process of reducing the thickness of passivation layers or to completely remove such passivation layers is, for example, disclosed in EP 844 650 A2.

According to a particular embodiment of the solar cell according to the present invention the passivation layer on the back side is, at least in certain areas, completely removed by this treatment such that in these areas the p-type or n-type silicon is freely accessible. Suitable etching agents are aqueous solutions of at least one mineral acid, preferably an aqueous solution of HF or an aqueous solution of a mixture of HF and at least one further mineral acid selected from the group consisting of $H_2SO_4$, $H_3PO_4$, HBr, HI, $HClO_4$ and $HIO_4$. Particularly suitable is an aqueous hydrofluoric acid solution having a concentration the range from 0.1 to 5 wt.-%. Methods for etching $SiO_x$-layers on the surface of p-type or n-type silicon are disclosed, for example, in EP 844 650 A2.

The surface on the backs side of the substrate is covered with a conductive polymer layer, wherein this conductive polymer layer serves as a hole-transporting layer in the solar cell.

As a conductive polymer conjugated polymers such as polypyrroles, polythiophenes, polyani-lines, polyacetylenes or polyphenylenes can be used, wherein the use of polythiophenes is particularly preferred. According to a preferred embodiment of the solar cell according to the present invention the conductive polymer therefore comprises a polythiophene. Preferred polythiophenes are those having repeating units of the general formula (I) or (II) or a combination of units of the general formulas (I) and (II), preferably a polythiophene with repeating units of the general formula (II):

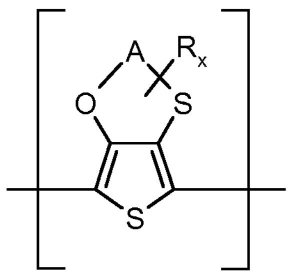

(I)

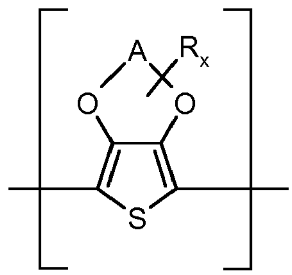

(II)

wherein

A stands for an optionally substituted $C_1$-$C_5$-alkylene radical,

R stands for a linear or branched, optionally substituted $C_1$-$C_{18}$-alkyl radical, an optionally substituted $C_5$-$C_{12}$-cycloalkyl radical, an optionally substituted $C_6$-$C_{14}$-aryl radical, an optionally substituted $C_7$-$C_{18}$-aralkyl radical, an optionally substituted $C_1$-$C_4$-hydroxyalkyl radical or a hydroxyl radical,

x stands for a whole number from 0 to 8 and

in the case where multiple radicals R are connected to A, these can be identical or different.

The general formulas (I) and (II) are to be so understood, that x substituents R can be connected to alkylene radical A.

Particularly preferred as polythiophene is poly(3,4-ethylenedioxythiophene).

The conductive polymer layer may further comprise a polymeric anion, preferably a polymeric anion based on polymers functionalised with acid groups, such as a polymeric sulfonic acids such as polystyrenesulphonic acids and polyvinylsulphonic acids, or a polymeric carboxylic acid. These polycarboxylic and -sulphonic acids can also be copolymers of vinylcarboxylic and vinylsulphonic acids with other polymerizable monomers, such as acrylic acid esters and styrene. Particularly preferably, the solid electrolyte comprises an anion of a polymeric carboxylic or sulphonic acid for compensation of the positive charge of the polythiophene.

The molecular weight of the polyacids which supply the polyanions is preferably 1,000 to 2,000,000, particularly preferably 2,000 to 500,000. The polyacids or their alkali metal salts are commercially obtainable, e.g. polystyrenesulphonic acids and polyacrylic acids, or can be prepared by known processes (see e.g. Houben Weyl, Methoden der organischen Chemie, vol. E 20 Makromolekulare Stoffe, part 2, (1987), p. 1141 et seq.).

Particularly suitable as polymeric anion is polystyrene sulphonic acids (PSS).

According to a particularly preferred embodiment of the solar cell according to the present invention the conductive polymer layer comprises a cationic conductive polymer, preferably a cationic polythiophene, as the conductive

polymer and a polymeric anion as a counter-ion for the cationic conductive polymer, preferably a polymeric sulfonic acid or a polymeric carboxylic acid, wherein it is particularly preferred that the cationic polythiophene and the polymeric anion are present in the form of a polythiophene : polymeric anion-complex, preferably a poly(3,4-ethylenedioxythiophene) : polystyrene sulfonic acid complex (also referred to as "PEDOT : PSS-complex"). Such a complex can be obtained if the monomers on which the polythiophene is based (such as 3,4-ethylenedioxythiophene) are polymerized in the presence of the polymeric anion in an aqueous solution as disclosed by Kirchmeyer et al. in the Journal of Materials Chemistry (2005), 15(21), pages 2077-2088. In this context it may be particularly preferred that the conductive polymer layer comprises the cationic conductive polymer, preferably poly(3,4-ethylenedioxythiophene), and the polymeric anion, preferably a polymeric sulfonic acid such as PSS, in a weight ratio cationic conductive polymer : polymeric anion of greater than 0.4, preferably greater than 0.5, more preferably greater than 0.6 and even more preferably greater than 0.65. If, for example, the polymeric layer comprises 1 part by weight of the cationic conductive polymer and 2 parts by weight of the polymeric sulfonic acid, the weight ratio cationic conductive polymer : polymeric acid would be 0.5 (i. e. 1 : 2).

The layer thickness of the conductive polymer layer preferably lies in a range from 1 nm to 10 μm, particularly preferably in a range from 10 nm to 500 nm and most preferably in a range from 20 nm to 200 nm. The surface resistance of the conductive polymer layer preferably lies in a range from 1 to 5000 Ω/sq, preferably in a range from 10 to 1000 Ω/sq and most preferably in a range from 10 to 250 Ω/sq.

The solar cell according to the present invention further comprises two metal containing layers forming the electrical poles of the solar cell.

According to a first particular embodiment of the solar cell according to the present invention the solar cell is configured to have a first electrode at the front side and a second electrode at the back side of the solar cell.

According to a second particular embodiment of the solar cell according to the present invention the solar cell is configured to have both electrodes on the back side of the solar cell. This structure is also called *"back contact, back junction (BCBJ) solar*".

Solar cell according to the first particular embodiment

In this particular embodiment the solar cell is configured to have a first electrode at the front side and a second electrode at the back side of the solar cell. In this context it is preferred that the solar cell comprises a first metal containing layer being in an electrically conductive contact with the front side of the substrate and a second metal containing layer being in an electrically conductive contact with the conductive polymer layer at the back side of the substrate.

The first metal containing layer being in an electrically conductive contact with the front side of the substrate is preferably applied in the form of a metal grid or in the form of a pattern comprising at least one metal busbar and metal fingers to allow light to be absorbed by the exposed silicon surface. The front grid or the front fingers can be deposited in embedded grooves to reduce shading losses. This type of solar cell is often known as a "*Buried Contact solar cell*" (also referred to as a "*Laser Grooved Baried Grid (LGBG) solar cell*". Such a solar cell is, for example, disclosed in EP 0 156 366 A2.

The metal containing layer at the front side of the substrate can, for example, be based on aluminum (Al), gold (Au), silver (Ag), nickel (Ni) coated with copper (Cu) or chromium (Cr) coated with gold(Au) or silver (Ag) or a stack comprising titanium (Ti), palladium (Pd) and silver (Ag). In industry, for forming a silver grid, a silver containing paste (which often includes silver particles, an organic binder and glass frit) is printed onto the wafers and then fired at temperature between 700°C and 900°C. The high-temperature firing of the silver paste ensures a good contact between silver and silicon, and lowers the resistivity of the silver lines. Furthermore, conventional thin film evaporation techniques, such as electron beam evaporation, can be used for forming a metal grid or a pattern comprising at least one metal busbar and metal fingers on the front surface of the solar cell. For forming the pattern shadow masks can be used or the pattern can be formed by means of conventional photolithographic techniques.

The second metal containing layer being in an electrically conductive contact with the conductive polymer layer at back side of the substrate is preferably applied directly onto the conductive polymer layer. As stated above, this "encapsulation" of the conductive polymer layer leads to an increased stability as the absorption of moisture by conductive polymer layer, in particular if this conductive polymer layer is based on PEDOT : PSS, is avoided. In this context it is preferred that at least 50 %, more preferably at least 75 % and even more preferred at least 95 % of the total surface of the conductive polymer layer is covered with the second metal containing layer, wherein it is most preferred that essentially the whole surface of the conductive polymer layer is covered with the second metal containing layer.

By directly applying the metal containing layer at the back side of the substrate to the conductive polymer layer, the following layer sequence is obtained at the back side:

- back side of the substrate (preferably the back side of the n-doped monocrystalline silicone wafer)
- conductive polymer layer, preferably a conductive polymer layer comprising a polythiophene

- metal containing layer (back side electrode)

The metal containing layer at the back side of the substrate can also be based on aluminum (Al), gold (Au), silver (Ag), nickel (Ni) coated with copper (Cu) or chromium (Cr) coated with gold (Au) or silver (Ag), or stacks comprising titanium (Ti), palladium (Pd) and silver (Ag), wherein a silver layer is preferred as the metal containing layer at the back side. For forming a silver layer, a silver-containing polymer-based paste can be applied onto the conductive polymer layer and then low-temperature fired at appropriate temperatures (i. e. < 200°C). Such pastes are commercially available and are today routinely used in the production of a-Si/c-Si heterojunction cells. Furthermore, conventional thin film evaporation techniques, such as electron beam evaporation or sputtering, can be used for applying a metal layer onto the conductive polymer layer.
The thickness of the metal containing layer at the back side of the substrate is usually within the range of 0.1 to 100 nm, more preferably within the range of 0.5 to 30 nm and most preferably within the range of 1 to 5 nm.
In connection with the solar cell according to the first particular embodiment it is furthermore preferred that the substrate, preferably the n-type monocrystalline silicon wafer, at the front side and beneath the passivation layer comprises an n-doped front surface field ($n^+$-FSF). If the substrate comprises an $n^+$-FSF, the metal containing layer at the front side of the substrate is in electrically conductive contact with at least a portion of the $n^+$-FSF.
The presence of a heavily doped region at the front side of the substrate allows much better electrical contact between the solar cell and the metallic contacts at the front side and significantly lowers the series resistance of the solar cell. The use of heavily n-doped regions on the front side surface also has the advantage of a higher efficiency of the solar cells due to reduced recombination losses under the metalized area due to the strongly reduced hole concentration within the $n^+$-FSF. The layer resistance of the $n^+$-FSF is preferably in a range of 10 to 500 ohm/sq.
Preferred n-type dopants according to the invention are those which add electrons to the Si wafer band structure. They are well known to the person skilled in the art. All dopants known to the person skilled in the art and which he considers to be suitable in the context of the invention can be employed as n-type dopant. Preferred n-type dopants according to the invention are elements of group 15 of the periodic table. Preferred group 5 elements of the periodic table in this context include N, P, As, Sb or a combination of at least two thereof, wherein P is particularly preferred. In one embodiment of the invention, the n-doped layer comprises P as dopant. An $n^+$-FSF can be made for example by means of a gas diffusion step at a temperature of 800-950°C for several tens of minutes, as described for example in document J.C.C. Tsai, "Shallow Phosphorous Diffusion Profiles in Silicon", Proc. of the IEEE 57 (9), 1969, p. 1499-1506, or by means of an ion implantation of phosphorus atoms, followed by a step of thermal activation of the implanted atoms, as described for example in the publication of Meier et al., "N-Type, ion Implanted silicon solar cells and modules", Proc. 37 th PVSC, LA, page 3337.

Solar cell according to the second particular embodiment

In this particular embodiment the solar cell is configured to have both electrodes on the back side of the solar cell ("*back contact, back junction* (*BCBJ*)"). In this embodiment the solar cell comprises a first metal containing layer being in an electrically conductive contact with the back side of the substrate and a second metal containing layer being in an electrically conductive contact with the conductive polymer layer on the back side of the substrate.
Such BCBJ-cell has a higher efficiency potential compared to a solar cell in which both sides are contacted as the shadowing at the front side can be omitted. With conventional high temperature diffusion, however, the processing is complex and requires a high number of process steps including masking steps for locally generating $n^+$- and $p^+$-regions on the back side of the cell. By local application of a conductive polymer layer such as a PEDOT : PSS-layer on the back side of the solar cell, for example by screen printing, the processing of such BCBJ-cell is greatly simplified as only the conventionally produced phosphorus-diffused $n^+$-region has to be masked. The conventionally produced $n^+$-region shows a higher recombination than the conductive polymer/n-Si -junction. However, since the $n^+$-contact region in n-type silicon based BCBJ-solar cells is advantageously limited to a small area (typically $\leq$ 20%) and as the conductive polymer/n-Si-junction is characterized by a good passivation effect, it is still possible to achieve a high efficiency with a simple process sequence.
In the second particular embodiment of the solar cell according to the present invention the back side of the solar cell comprises two patterned structures:

- In the first patterned structure selected regions on the back side of the substrate are provided with $n^+$-regions. The regions of this first patterned structure are in an electrically conductive contact with a first grid forming the first metal containing layer.

- In the second patterned structure in further selected regions on the back side of the substrate the p-type silicon or n-type silicon is at least partially in direct contact with the conductive polymer layer, preferably with a conductive

polymer layer comprising a polythiophene. The regions of this patterned structure are in contact with a second grid forming the second metal containing layer.

In this context it is preferred that not more than 50 %, preferably not more than 30 % and most preferably not more than 20 % of the total area on the back side of the solar cell is provided with an $n^+$-regions.

In addition to the layers described above which directly contribute to the principle function of the solar cell according to the present invention, in particular the solar cell according to the above described first and second particular embodiment, further layers can be added for mechanical and chemical protection.

The solar cell can be encapsulated to provide chemical protection. Encapsulations are well known to the person skilled in the art and any encapsulation can be employed which is known to him and which he considers suitable in the context of the present invention. According to the present invention, transparent polymers, often referred to as transparent thermoplastic resins, are preferred as the encapsulation material, if such an encapsulation is present. Preferred transparent polymers in this context are for example silicon rubber and polyethylene vinyl acetate (PVA).

A transparent glass sheet can be added to the front side of the solar cell to provide mechanical protection. Transparent glass sheets are well known to the person skilled in the art and any transparent glass sheet known to him and which he considers to be suitable in the context of the present invention can be employed as protection on the front side of the solar cell.

A back protecting material can be added to the back side of the solar cell to provide mechanical protection. Back protecting materials are well known to the person skilled in the art and any back protecting material which is known to the person skilled in the art and which he considers to be suitable in the context of the present invention can be employed as protection on the back face of the solar cell. Preferred back protecting materials according to the present invention are those having good mechanical properties and weather resistance. The preferred back protection material according to the present invention is polyethylene terephthalate with a layer of polyvinyl fluoride. It is preferred according to the present invention for the back protecting material to be present underneath the encapsulation layer (in the event that both a back protection layer and encapsulation are present).

A frame material can be added to the outside of the solar cell to give mechanical support. Frame materials are well known to the person skilled in the art and any frame material known to the person skilled in the art and which he considers suitable in the context of the present invention can be employed as frame material. The preferred frame material according to the present invention is aluminum.

A contribution to achieving at least one of the above described objects is also made by a process for the preparation of a solar cell comprising the process steps:

I) providing a substrate of p-type silicon or n-type silicon, wherein the substrate comprises

- a front side
  and
- a back side;

II) treatment of the back side with an etching agent;

III) covering at least a part of the treated surface on the back side of the substrate with a layer of a conductive polymer, wherein at least one of the following conditions A) and B) is fulfilled:

A) in process step III) the treated surface on the back side of the substrate is brought into contact with the layer of a conductive polymer in such a way that the conductive polymer layer is at least partially in direct contact with the surface of the p-type or n-type silicon;

B) the conductive polymer layer comprises a cationic conductive polymer and a polymeric anion in a weight ratio cationic conductive polymer : polymeric anion of greater than 0.4;

IV) optionally covering at least a part of the surface of the conductive polymer layer with a metal containing layer.

According to a first particular embodiment of the process according to the present invention condition A) is fulfilled. According to a second particular embodiment of the process according to the present invention condition B) is fulfilled. According to a third particular embodiment of the process according to the present invention conditions A) and B) are fulfilled.

In process step I) of the process according to the present invention a substrate of p-type silicon or n-type silicon is provided, wherein the substrate comprises a front side and a back side. Preferred substrates are those that have

already been mentioned as preferred substrates in connection with the solar cell according to the present invention, wherein a n-doped monocrystalline silicon wafer is the most preferred substrate.

As already described in connection with the solar cell according to the present invention the front side of the substrate (i. e. the side that is exposed to the sun light) can have a texture with maxima and minima, wherein those textures are preferred that have already been described in connection with the solar cell according to the present invention (i. e. a concave and convex pattern with a minute pyramid (i. e. square pyramid) shape).

The front side of the substrate that is provided in process step I) may at least partially be covered with at least one passivation layer. However, it is also possible to apply such a passivation layer (or such passivation layers) onto the surface of the front side of the substrate after performing process step II) or process step III). Preferred passivation layers are again those passivation layers that have already been described in connection with the solar cell according to the present invention (i. e. silicon nitride layers, silicon oxide layers ($SiO_x$), in particular a $SiO_2$ layer, silicon carbide layers (SiC), titanium oxide layers ($TiO_x$), in particular a $TiO_2$ layer, aluminium oxide layers ($AlO_x$), in particular a $Al_2O_3$ layer, a layer of amorphous silicon (a-Si), in particular a layer of n-doped amorphous silicon (a-Si (n)) or a layer stack comprising of an intrinsic undoped amorphous silicon layer (a-Si (i)) and Si n- or p-doped amorphous silicon layer (a-Si (n)), in particular a double layer stack consisting of an a-Si0 (i)-layer and an a-Si (n)-layer, or a combination of at least two of these layers), wherein layers of $SiN_x$ are most preferred. These layers may also simultaneously function as anti-reflection layers, as already mentioned in connection with the solar cell according to the present invention. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO).

The application of the above mentioned layers can be performed by means of PECVD (plasma enhanced chemical vapor deposition), APCVD (atmospheric pressure chemical vapor deposition) or atomic layer deposition (ALD).

Depending on the kind of solar cell that is produced by the process according to the present invention (i. e. a solar cell that is configured to have a first electrode at the front side and a second electrode at the back side of the solar cell or a solar cell that is configured to have both electrodes on the back side of the solar cell) the substrate provided in process step I) may comprise further layers.

- If the solar cell is configured to have a first electrode at the front side and a second electrode at the back side of the solar cell, the substrate may further comprise a n-doped front surface field ($n^+$-FSF) as described in connection with the first particular embodiment of the solar cell according to the present invention. This n-doped front surface field may further be in an electrically conductive contact with the first electrode, which may have been applied in the form of a grid or in the form of a pattern comprising at least one metal busbar and metal fingers.

- If the solar cell is configured to have both electrodes on the back side of the solar cell, the substrate may comprise $n^+$-areas in the form of a pattern on the back side of the solar cell, as already described in connection with the second particular embodiment of the solar cell according to the present invention.

The back side of the substrate of p-type silicon or n-type silicon that is provided in process step I) may comprise a passivation layer. As explained above, such a passivation layer may have been applied intentionally on the back side of the substrate (for example to protect the back side in previous fabrications steps or as a result of the formation of a passivation layer on the front side) or may have been formed unintentionally while storing the substrate at ambient air (which leads to the formation of an $SiO_x$-based passivation layer). To decrease the thickness of such a passivation layer or preferably to at least partially remove such a passivation layer to such an extend that at least in certain areas on the backside of the solar cell the p-type silicon or n-type silicon is freely accessible, the back side is treated with an etching agent in process step II). As stated above, suitable etching agent are aqueous solutions of at least one mineral acid, preferably an aqueous solution of HF or an aqueous solution of a mixture of HF and at least one further mineral acid selected from the group consisting of $H_2SO_4$, $H_3PO_4$, HBr, HI, $HClO_4$ and $HIO_4$. Particularly suitable is an aqueous hydrofluoric acid solution having a concentration the range from 0.1 to 5 wt.-%. Methods for etching $SiO_x$-layers on the surface of p-type or n-type silicon are disclosed, for example, in EP 844 650 A2.

Preferably, the back side is treated with the etching agent to such an extent that at least 5 %, preferably at least 25 %, more preferably at least 50 %, even more preferably at least 75 % and most preferably at least 95 % of the surface of the p-type or n-type silicon on the back side of the substrate are freely exposed so that in process step III) the p-type or n-type silicon can come into direct contact with the conductive polymer layer. According to a particular preferred embodiment of the process according to the present invention the back side is treated with the etching solution to such an extent that the complete surface of the p-type or n-type silicon on the back side of the substrate is freely exposed. It is, however, also possible that the back side is treated with the etching agent only to such an extent that in up to 95 %, preferably in up to 75 %, more preferably in up to 50 %, even more preferably in up to 25 % and most

preferably in up to 5 % of the surface on the back side of the substrate the p-type or n-type silicon does not come direct contact with the conductive polymer layer that is applied in process step III). In these areas a thin passivation layer, preferably a $SiO_x$ layer, may remain on the surface on the back side of the substrate. The thickness of the passivation layer, preferably of the $SiO_x$-layer, is preferably in the range from 0.2 nm to 1.0 nm. In the case of a $SiO_2$-layer the thickness of the passivation layer in these areas is preferably within about one or two monolayers of silicon dioxide.

In process step III) of the process according to the present invention the treated surface on the back side of the substrate is covered with a conductive polymer layer, wherein as conductive polymer those polymers are preferred that have already been mentioned as the preferred conductive polymers in connection with the solar cell according to the present invention. According to a particularly preferred embodiment of the process according to the present invention the conductive polymer layer prepared in process step III) comprises a polythiophene, preferably a cationic polythiophene that is present in the form of a polythiophene : polymeric anion-complex, wherein those polythiophenes and polymeric anions are preferred that have already been mentioned in connection with the solar cell according to the present invention.

According to a preferred embodiment of the process according to the present invention the conductive polymer layer is formed by applying a liquid composition comprising the conductive polymer and a solvent onto the back side of the substrate and by subsequently removing at least a part of the solvent. Depending on the chemical nature of the conductive polymer and the presence or absence of further compounds such as polymeric anions the liquid composition can be a solution, a dispersion or an emulsion. In the case of a complex of a cationic polythiophene and a polymeric anion, such as a PEDOT : PSS-complex, these complexes are, when being dispersed in water as the solvent, present in the form of swollen gel particles. In the present invention such a system of swollen gel particles in an aqueous system is considered as a dispersion. Suitable solvents are water, lower alcohols such as methanol, ethanol, 1-propanol, 2-propanol or iso-propanol or mixtures of water and one or more of these lower alcohols.

The liquid composition, preferably the dispersion, may further comprise a polymeric anion, wherein preferred polymeric anions are those that have already been mentioned in connection with the solar cell according to the present invention. Particularly preferred liquid compositions are those comprising a polythiophene : polymeric anion complex, in particular solutions, emulsions or dispersions comprising PEDOT : PSS. As stated above, such liquid compositions can be obtained if the monomers on which the polythiophene is based (such as 3,4-ethylenedioxythiophen) are polymerized in the presence of the polymeric anion in an aqueous solution. In this context it may be particularly advantageous to use a liquid composition comprising a cationic conductive polymer, preferably a cationic polythiophene, and a polymeric anion, preferably a polymeric sulfonic acid such as PSS, in a weight ratio cationic conductive polymer : polymeric anion of greater than 0.4, preferably greater than 0.5, more preferably greater than 0.6 and even more preferably greater than 0.65.

The liquid compositions used to prepare the conductive polymer layer can be applied onto the back side of the substrate by known processes, for example by spin-coating, impregnating, casting, drop wise application, spraying, knife-coating, painting or printing, for example inkjet printing, screen printing or pad printing, wherein the method of applying the liquid composition also depends on the structure of the solar cell. If, for example, the solar cell is configured to have both electrodes on the back side of the solar cell and if therefore the layer of the conductive polymer has to be applied in the form of a pattern to only cover selected areas of the back side of the solar cell, techniques such as inkjet printing are preferred.

After the liquid composition has been applied, the solvent is preferably removed for the formation of the conductive polymer layer. Removal of the solvent is preferably achieved by simple evaporation at a drying temperature in the range from 10 to 250°C, preferably 50 to 200°C and more preferably 80 to 150°C for a period of 1 second to 24 hours, preferably 10 seconds to 10 minutes and more preferably 15 seconds to 2 minutes. The thickness of the conductive polymer layer thus applied preferably lies in a range from 1 nm to 10 μm, particularly preferably in a range from 10 nm to 500 nm and most preferably in a range from 20 nm to 200 nm. The surface resistance of the conductive polymer layer thus applied preferably lies in a range from 1 to 5000 Ω/sq, preferably in a range from 10 to 1000 Ω/sq and most preferably in a range from 10 to 250 Ω/sq.

In process step IV) of the process according to the present invention at least a part of the surface of the conductive polymer layer (i. e. the surface facing away from the back side of the substrate) may optionally be covered with a metal containing layer, wherein the way of covering the conductive polymer layer with the metal containing layer again depends on the structure of the solar cell.

- If the solar cell is configured to have a first electrode at the front side and a second electrode at the back side of the solar cell, it is preferred that almost the entire surface of the back side of the substrate is covered with a conductive polymer layer and that almost the entire surface of the conductive polymer layer is covered with the metal containing layer serving as the electrode on the back side of the solar cell. In this embodiment the second electrode of the solar cell is applied in the form of a grid of in the form of a pattern comprising at least one metal busbar and metal fingers at the front side of the solar cell.

- If the solar cell is configured to have both electrodes on the back side of the solar cell, the metal containing layer is only applied onto those areas on the back side of the solar cell which are covered with the conductive polymer layers. The remaining areas (i. e. the $n^+$-areas) are covered by a separate metal containing layer.

The metal containing layer that is used to cover the conductive polymer layer comprising polythiophenes can be based on aluminum (Al), gold (Au), silver (Ag), nickel (Ni) coated with copper (Cu) or chromium (Cr) coated with Au or a stack comprising titanium (Ti), palladium (Pd) and silver (Ag), wherein a silver layer is preferred as the metal containing layer at the back side. For forming a silver layer, a silver-containing polymer-based paste can be applied onto the conductive polymer layer and then low-temperature fired at appropriate temperatures (i.e. <200°C). Such pastes are commercially available and are today routinely used in the production of a-Si/c-Si heterojunction cells. The way of applying the metal containing layer again depends on the solar cell that is prepared (i. e. if the metal containing layer is applied extensively onto the whole surface of the back side of the substrate, as it is the case for the first particular embodiment of the solar cell according to the present invention, or if the metal containing layer is applied in the form of a pattern only onto selected areas on the back side of the substrate, as it is the case for the second particular embodiment of the solar cell according to the present invention).

A contribution to achieving at least one of the above mentioned objects is also made by a solar cell obtainable by the process according to the present invention.

A contribution to achieving at least one of the above mentioned objects is also made by a module comprising at least one solar cell according to the present invention or at least one solar cell obtained by the process according to the present invention, in particular according to at least one of the above described embodiments, and at least one further solar cell, wherein the at least one further solar cell can be a solar cell according to the present invention or a solar cell obtained by the process according to the present invention, or a solar cell of the prior art. A multiplicity of solar cells according to the present invention can be arranged spatially and electrically connected to form a collective arrangement called a module. Preferred modules according to the present invention can take a number of forms, preferably a rectangular surface known as a solar panel. Large varieties of ways to electrically connect solar cells as well as large varieties of ways to mechanically arrange and fix such cells to form collective arrangements are well known to the person skilled in the art and any such methods known to him and which he considers suitable in the context of the present invention can be employed. Preferred methods according to the present invention are those which result in a low mass to power output ratio, low volume to power output ration, and high durability. Aluminium is the preferred material for mechanical fixing of solar cells according to the present invention.

DESCRIPTION OF THE DRAWINGS

The present invention is now explained by means of figures and examples, wherein the figures are intended for illustration only and are not to be considered as limiting the scope of the present invention. In brief,

Fig. 1 shows a side view of a solar cell 1 according the first particular embodiment of the present invention, wherein a first electrode 6 is localized at the front side 2a and a second electrode 5 is localized at the back side 2b of the solar cell 1;

Fig. 2 shows a cross sectional view of the solar cell 1 shown in fig. 1;

Fig. 3 shows a cross sectional view of a solar cell 1 according the second particular embodiment of the present invention, wherein both electrodes 5,6 are localized at the back side 2b of the solar cell 1 ("*back contact, back junction (BCBJ)*").

Figures 1 and 2 show a realization form of the solar cell 1 according the first particular embodiment of the present invention, wherein a first electrode 6 is localized at the front side 2a and a second electrode 5 is localized at the back side 2b of the substrate 2. This solar cell structure is characterized by a conventionally processed RP-textured front side 2a that was provided with a phosphorus-diffused electron collecting $n^+$-layer 2' (the so called "*$n^+$-Front Surface Field*", $n^+$-FSF). The front side 2a (i. e. the $n^+$-FSF) was coated with an $Al_2O_3$ tunnel layer 3', metallized with aluminum and then passivated with a $SiN_x$-layer 3". The front side 2a was made with a standard process developed by the Institute for Solar Energy Research Hamelin (ISFH) and described by D. Zielke et al., "Contact passivation in silicon solar cells using atomic-layer-deposited aluminum oxide layers". Phys. Stat. Sol. RRL 5, 298-300 (2011). On the back side 2b of the solar cell 1 the hole-transporting PEDOT : PSS/c-Si heterojunction is localized, which was completely metallized with evaporated silver (Ag) forming the back electrode 5.

For the production of the solar cell 1 as shown in figures 1 and 2 (and as performed in the examples below) a boron-doped (p-type) float-zone (FZ) silicon wafer 2 having a specific resistivity (p) of 0.5 to 1.5 Ωcm and a thickness

of 300 μm and phosphor-doped (n-type) Czochralski (Cz) silicon wafer 2 having a specific resistivity of 1.5 to 5 Ωcm and a (100)-orientation are used as the starting materials. The wafers are cut into 2.49 × 2.49 $cm^2$ probes by means of a laser. The wafers 2 are cleaned with an RCA sequence and protected on both sides with a $SiN_x$-layer having a thickness of 100 nm (index of refraction: 1.9 at a wavelength of 632 nm) and being deposited by PECVD. On one side of the passivated silicon wafer 2 (subsequently referred to as the front side) a 2 × 2 cm diffusion window was opened in the $SiN_x$ layer by laser ablation (frequency-doubled Nd : $YVO_4$ laser, SuperRapid, Lumera ). After cleaning the probes in solutions of $H_2O$:HCl:$H_2O_2$ and $H_2O$:$NH_4$:$H_2O_2$ having a temperature of 80°C a random pyramid texture is produced in the opened $SiN_x$-windows by means of a KOH/isopropanol solution. During texturing randomly distributed pyramids having a size of about 5 μm are formed on the surface of the silicon while the $SiN_x$-layer is not affected. After further RCA-cleaning, phosphorus diffusion is performed in the open and textured $SiN_x$ window with a $POCl_3$ source in a quartz tube furnace at 850°C. The resulting $n^+$-FSF 2' has a sheet resistance of about 100 Ω/sq at a pore deepness of about 0.4 μm. The $SiN_x$ protective layer and the phosphorus-silicate glass are completely removed using a 5 % fluoric acid solution that is applied for 1 hour and, after a further RCA-cleaning, the textured side of the wafer 2 is coated with an $Al_2O_3$ tunnel layer 3' having a thickness of 0.24 nm and being deposited by means of atomic layer deposition. Thereafter, an aluminum grid 7 with a thickness of 20 μm and a finger pitch of 1 mm is deposited by electron beam evaporation using nickel shadow masks on the textured front side 2a. By means of an aluminium etching solution the aluminium under depositions is removed and the front side 2a is subsequently coated with a passivating $SiN_x$ layer having a refractive index of 2.4 and at a wavelength of 632 nm and a thickness of 10 nm. Without breaking the vacuum a 70 nm thick $SiN_x$ anti-reflection layer having a refractive index of 1.9 at a wavelength of 632 Nm was applied. The two $SiN_x$ layers together are indicated by reference number 3" in figure 2 and are deposited at 330°C by PECVD. After depositing $SiN_x$ the probes are tempered at 350°C for 2 min under air in order to improve the metal contact at the front side.

Before depositing PEDOT/PSS at the back side the probes are etched for 1 minute in a 1 % aqueous solution of HF. Immediately after this treatment a PEDOT : PSS layer 4 having a thickness of 140 nm has been applied onto the back side 2b of the probe by spin coating (500 revolutions per minute for 10 seconds, followed by 1000 rpm for 30 seconds) a PEDOT : PSS-dispersion (i. E. dispersions Example 3 as described below) on the untextured side of the cell. The cells are then dried at 130°C for 15 minutes on a hot plate. The resultant PEDOT : PSS layer 4 that has been deposited at the back side 2b of the solar cell 1 has a thickness of about 50 to 200 nm. Finally, the entire surface of the PEDOT : PSS layer 4 is coated with a silver layer 5. The silver coating has been performed by electron beam evaporation

As a full-surface silver vapor-deposition is rather uneconomic for an industrially manufactured solar cell, the back side 2b can also be metallized by other methods. One approach that is used in industry for many years in connection with a-Si/c-Si heterojunction cells is the use of silver-containing polymer pasts. In this approach a silver containing paste that can be tempered at temperatures that are compatible with PEDOT : PSS is applied by screen printing and is subsequently tempered. Another possibility of applying a metallic layer on the back side of the solar cell is the use of galvanic deposition.

Figure 3 shows a cross sectional view of a solar cell 1 according the second particular embodiment of the present invention, wherein both electrodes 5,6 are localized at the back side 2b of the substrate 2 ("*back contact, back junction* (*BCBJ*)"). This solar cell structure characterized in that the front side 2a is completely non metallized and is only RP-textured to improve light coupling. The front side is passivated with a $SiO_2$/$SiN_x$-layer sequence 3',3" (wherein the $SiN_x$-layer is the outer layer), which also acts as an anti-reflection coating. On the back side 2b phosphorus-diffused $n^+$-regions 2' for contacting the n-type substrate 2 are produced locally and, as a hole-conducting layer, a conductive polymer layer 4 is applied. Metallization is effected by means of two independent grids 5,6, which are electrically isolated by gaps. The non-metallized part of the $n^+$- region as well as the gap between the $n^+$-region 2' and the conductive polymer layer 4 on the back side 2b of the substrate 2 are treated with an etching solution such as an aqueous solution of HF in order to at least partially remove impurities or a Si-$O_x$-layer which may have formed before the conductive polymer layer 4 is applied.

For preparing a BCBJ-solar cell 1 shown in figure 3 a monocrystalline n-type silicon wafer 2 with a resistivity of 1-6 Ωcm and a thickness of 160 μm is used as the starting material. The wafer 2 is cleaned with an RCA sequence and protected on one side with a $SiN_x$-layer having a thickness of 100 nm and being deposited by PECVD. On the uncoated side of the wafer 2 a random pyramid (RP) texture is produced in a KOH/isopropanol solution. After wet-chemical cleaning the RP-textured side 2a of the wafer 2 is protected with a PECVD-deposited $SiN_x$ layer. Thereafter strips with a width of 200 μm and a distance of 2 mm from each other are opened on the untextured, planar side 2b of the wafer 2 in the $SiN_x$ protective layer by laser ablation (frequency-doubled Nd: YVO4 laser, Super Rapid, Lumera). After wet-chemical cleaning, a phosphorus diffusion is performed in the open areas on the untextured side 2b. The diffusion is accomplished with a $POCl_3$ source in a quartz tube furnace at 850°C. The resulting $n^+$-regions 2' have a sheet resistance of 100 ± 70 Ω/sq. The $SiN_x$ protective layers and the phosphorus-silicate glass are completely removed using diluted fluoric acid solution and the wafer 2 is oxidized on both sides in a quartz tube furnace at 900°C in a wet oxidation in order to grow a 10 nm $SiO_x$ passivation layer on both surfaces. Onto the $SiO_x$ passivation layer 3' on the textured front side 2a a $SiN_x$-layer 3" having a thickness of 80 nm is deposited by PECVD to improve the anti-reflection

effect and the passivation effect on the front side 2a. On the back side 2b the $SiO_x$ layer is removed by etching in hydrofluoric acid. Immediately after removing the $SiO_x$-layer at the back side 2b the conductive polymer layer 4, such as a PEDOT : PSS layer, is locally applied in the regions between the $n^+$-type lines. This can, for example, be effected by means of screen printing or inkjet printing. The solar cell 1 is then dried at 130°C for 30 seconds on a hot plate. The sheet resistance of the PEDOT : PSS layer 4 that has been deposited at the back side 2b of the solar cell 1 is 120 ± 10 Ω/sq. Finally, the PEDOT : PSS layer 4 is metallized locally with a first grid 5 that only contacts the PEDOT : PSS layer 4, and a second, finer grid 6 that contacts the $n^+$-regions 2'.

METHODES AND SUBSTRATES

Substrates:

In the case of p-type silicon a boron doped float zone silicon with a resistivity (p) of 150 Ωcm and a thickness of 300 μm was used. In the case of n-type silicon a phosphorus doped Czochralski (Cz) Silicon with a resistivity (p) of 4 Ωcm and a thickness of 160μm and a (100)-Orientation was used as basis. All wafers were cut into in 2.49 × 2.49 $cm^2$ sample size and subjected to RCA cleaning.

Solids content:

The solids content was determined gravimetric using a precision scale (Mettler AE 240). First the empty weighing bottle including lid is weight (weight A). Then ca. 3 g of dispersion to be analyzed is filled quickly into the bottle, closed by the lid and weighed again to determine the exact total weight B. The bottle is then placed in a drying oven with ventilation (Memmert UNB200) at 100°C for 16 hours. When the sample bottle is removed from the oven, immediate coverage by the glass lid is important due to the hygroscopic nature of the dry dispersion material. After 10-15 min of cooling down period the bottle is weighed again including lid to determine weight C. There is always a repeat determination of 2 samples.

Calculation of the solids contents: wt.% solids content = 100 x (C-A)/(B-A)

Electrical conductivity:

The electrical conductivity means the inverse of the specific resistance. The specific resistance is calculated from the product of surface resistance and layer thickness of the conductive polymer layer. The surface resistance is determined for conductive polymers in accordance with DIN EN ISO 3915. In concrete terms, the polymer to be investigated is applied as a homogeneous film by means of a spin coater to a glass substrate 50 mm × 50 mm in size thoroughly cleaned. In this procedure, the coating composition was applied onto the electrode by means of a pipette to completely cover the area. Excess dispersion was spun off. Films are dried at 130°C for 15 min. This leads to a 50 -150 nm thick homogenous layer for all materials.

In all cases silver electrodes of 2.0 cm length at a distance of 2.0 cm are vapour-deposited on to the polymer layer via a shadow mask. The square region of the layer between the electrodes is then separated electrically from the remainder of the layer by scratching two lines with a scalpel. The surface resistance is measured between the Ag electrodes with the aid of an ohm-meter (Keithley 614). The thickness of the polymer layer is determined with the aid of a Stylus Profilometer (Dektac 150, Veeco) at the places scratched away.

EXAMPLES

Example 1: synthesis of PEDOT : PSS with 28.6% (w/w) PEDOT (comparative)

A 3L stainless steel vessel equipped with a stirrer, an ultra-turrax, a thermostat and a vacuum pump was filled with 2050 g water , 500 g polystyrene sulfonic acid (5,0% solids) and 5.6 g of a 10% iron (III) sulfate solution. The mixture was stirred at 50 rpm. The temperature was adjusted to 18°C. Nitrogen was bubbled through the mixture for 3 h at 200 L/h. After 3 h 10 g ethylenedioxythiophene are added (Clevios M V2, Heraeus, Germany) via a syringe. Subsequently 23.7 g sodium peroxodisulfate are added under nitrogen. The vessel was closed and evacuated to 30 hPas using a vacuum pump. The mixture was stirred for 23 h at 18°C using stirrer and ultra-turrax. The mixture was then transferred to a beaker and mixed with 500 ml cation exchange resin (Lewatit S108 H, Lanxess AG, Germany) and 290 ml anion exchange resin (Lewatit MP 62, Lanxess AG, Germany). The mixture was stirred for 6 h and the ion exchange resins

were then removed by filtration. Subsequently the mixture was subjected to high pressure homogenization five times at 1000 bar and filtered through a 0.3μm filter.

240 g of the mixture were mixed with 12.6 g dimethylsulfoxide (Aldrich) and a mixture of 0,25 g Dynol 604 (Air products) and 0,25 isopropanol.

Analytics:

| | |
|---|---|
| Conductivity: | 672 S/cm |
| Solids: | 1.29 % |
| Viscosity: | 47 mPas [20°C; 100 $s^{-1}$] |

Example 2: synthesis of PEDOT : PSS with 40% (w/w) PEDOT (inventive)

A 3L stainless steel vessel equipped with a stirrer, an ultra-turrax, a thermostat and a vacuum pump was filled with 2000 g water , 52,7 g polystyrene sulfonic acid (28,6% solids), 4,6 g of a 10% iron (III) sulfate solution, and 9,3 g sulfuric acid. The mixture was stirred at 50 rpm. The temperature was adjusted to 18°C. Nitrogen was bubbled through the mixture for 3 h at 200 L/h. After 3 h 10.04 g ethylenedioxythiophene are added (Clevios M V2, Heraeus, Germany) via a syringe. Subsequently 13.9 g sodium peroxodisulfate are added under nitrogen. The vessel was closed and evacuated to 30 hPas using a vacuum pump. The mixture was stirred for 23 h at 18°C using stirrer and ultra-turrax. The mixture was then transferred to a beaker and mixed with 400 ml cation exchange resin (Lewatit S108 H, Lanxess AG, Germany) and 400 ml anion exchange resin (Lewatit MP 62, Lanxess AG, Germany). The mixture was stirred for 6 h and the ion exchange resins were then removed by filtration. Subsequently the mixture was subjected to high pressure homogenization five times at 1500 bar concentrated using ultrafiltration and subjected to high pressure homogenization again five times at 1500 bar. Finally the material was filtered through a 0.3μm filter.

240 g of the mixture were mixed with 12.6 g dimethylsulfoxide (Aldrich) and a mixture of 0,25 g Dynol 604 (Air products) and 0,25 isopropanol.

| | |
|---|---|
| Conductivity: | 633 S/cm |
| Solids: | 1.65 % |
| Viscosity: | 82 mPas [20°C; 100 $s^{-1}$] |

Table 1 shows the PEDOT : PSS ratio, solids content and conductivity of PEDOT : PSS grades prepared in Example 1 and 2

| | PEDOT concentration [%] w/w | Solids content [%] | Conductivity [S/cm] |
|---|---|---|---|
| Example 1 | 28.6 | 1.29 | 672 |
| Example 2 | 40.0 | 1.65 | 633 |

Example 3: measurement of resistance and saturation current density $J_0$ for example 1 after HF cleaning (inventive with respect to HF treatment)

Sample preparation

p- and n-type wafers were used. A 100 nm thick $SiN_x$ passivation layer (refractive index 2.4 at 632 nm wavelength) was deposited via plasma enhanced chemical vapor deposition (PECVD) on one side of the wafer. This side will be referred to as back-side within Example 3 and 4. The deposition temperature was 400°C and the time 5 min. After $SiN_x$ Deposition the sample was placed into a 1% HF solution in order to remove any undefined $SiO_x$ Layer on the front side that may have been generated during PECVD deposition.

PEDOT:PSS Deposition

The PEDOT : PSS dispersions described in Example 1 was deposited on the front side of the substrate via

spin-coating - spinning at 500 rpm for 10 sec and 1000 rpm for 30 sec. Subsequently the layers are dried for 30 sec at 130°C in air.

Sheet resistance and saturation current density

The measurement of the effective lifetime and the sheet resistance were done using a lifetime-tester (WCT-120 Sinton Instruments, USA). The saturation current density $J_0$ is calculated from the slope of the inverse effective lifetime as a function of the excess carrier density. The results are shown in Table 2.

Example 4: measurement of resistance and saturation current density $J_0$ for example 2 after HF cleaning (inventive with respect to PEDOT : PSS and HF treatment)

The procedure of Example 4 was repeated using PEDOT : PSS prepared in Example 2. The results are shown in Table 2.

Example 5: measurement of resistance and saturation current density $J_0$ for example 3 after HF cleaning and oxygen plasma treatment (comparative)

The procedure of Example 4 was repeated. After the HF dip on the front side a SiOx layers is deposited using oxygen plasma in an ALD FlexAL reactor (Oxford Instruments, United Kingdom). The front side is exposed to the plasma twice for two seconds. Subsequently the PEDOT : PSS dispersion prepared in Example 2 is deposited. The results are shown in Table 2.

Table 2: sheet resistance $R_{sheet}$ and saturation current density $J_0$ of PEDOT : PSS dispersions of Example 1 and 2 on p-type and n-type silicon and on oxygen plasma treated substrate.

| Example | substrate treatment | PEDOT: PSS dispersion | PEDOT concentration (wt.-%) | p-type | | n-type | |
|---|---|---|---|---|---|---|---|
| | | | | $J_0$ (fA/cm$^2$) | Rsheet (Ohm/sq) | $J_0$ (fA/cm$^2$) | $R_{sheet}$ (Ohm/sq) |
| 3 | HF | Example 1 | 28,6 | 145 ± 6 | 168 ± 1 | 154 ± 10 | 177 ± 1 |
| 4 | HF | Example 2 | 40,0 | 88 ± 1 | 154 ± 4 | 76 ± 2 | 151 ± 2 |
| 5 | HF followed by oxygen plasma | Example 2 | 40,0 | 1091 | 187 ± 10 | - | - |

Table 2 shows that the use of PEDOT : PSS as prepared in Example 2 leads to a reduction in sheet resistance and saturation current density. Both are important factors for the preparation of highly efficient devices. Table 2 shows furthermore that the absence of a $SiO_x$ layer as obtained by immediate deposition of PEDOT : PSS onto the silicon wafer leads to low sheet resistance and saturation current density, whereas the introduction of a $SiO_x$ layer by oxygen plasma increases both values.

Example 6: solar cell based on PEDOT : PSS Example 2 in the absence of passivation layer between Silicon and PEDOT : PSS (inventive)

A 2.49×2.49 cm$^2$ p-type substrate was subjected to RCA cleaning. After cleaning, the samples were protected on both surfaces with a 100 nm thick plasma-enhanced chemical vapor deposited (PECVD) $SiN_x$ layer (refractive index 1.9 @ $\lambda$ = 632 nm). On the front surface a 2 × 2 cm$^2$ diffusion window was opened by laser ablation (frequency-doubled Nd:YVO4 laser, SuperRapid, Lumera Laser). After ablation samples were cleaned in a $H_2O$ : HCl: $H_2O_2$ and $H_2O$: $NH_4OH$ : $H_2O_2$ solution at a temperature of 80 °C. Within the ablated window the silicon surface was random-pyramid (RP) textured in a KOH/iso-propanol solution. RP-texturing results in ~5 µm large random-pyramids on the silicon surface within the ablated window, while the SiNx protected area is not affected. Subsequently after RCA-cleaning, a phosphorus diffusion was performed from a $POCl_3$ source in a quartz-tube furnace at 850 °C forming a front surface field (FSF) with a sheet resistance of ~ 100 Ω/sq and a profile depth of ~ 0.4 µm. $SiN_x$ protecting layer and the phosphorus silicate glass were removed in a 5 % hydrofluoric acid solution for 1 h. After an additional RCA-clean, an 0.24 nm $AlO_x$ tunneling layer was atomic-layer-deposited (FlexAL, Oxford Instruments) on the front surface. Next, an aluminum grid was deposited through a nickel shadow mask by electron beam evaporation. In an etching bath the residual aluminum is removed.

After metallization, the front surface was covered by a 10 nm surface-passivating $SiN_x$ layer with a refractive index of 2.4 and by a 70 nm $SiN_x$ anti-reflection layer with a refractive index of 1.9 on top. Both $SiN_x$ layers were deposited at a temperature of 330 °C using PECVD. Afterwards, the samples were annealed in air for 2 min at 350 °C in order to improve the front surface passivation.

Before PEDOT : PSS deposition the samples were dipped in a 1 % HF solution for 1 min. Immediately after HF-dip (~20 min) a PEDOT : PSS from Example 2 was deposited by spin-coating on the entire rear at 500 revolutions per minute (rpm) for 10 seconds and subsequently 1000 rpm for 30 seconds. The sample was then dried on a hotplate in air at 130 °C for 15 min. PEDOT : PSS thickness is approximately 50 nm. Finally, the entire rear surface was metalized by electron beam evaporated silver.

The sample solar cell is characterized using a commercial IV-tester "cetisPV-CTL1" from Halm Elektronik GmbH. All parts of the measurement equipment as well as the solar cell to be tested were maintained at 25 °C during electrical measurement. This temperature is always measured simultaneously on the cell surface during the actual measurement by a temperature probe. The Xe Arc lamp simulates the sunlight with a known AM1.5 intensity of 1000 $W/m^2$ on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The numbers of contact probe lines are adjusted to the number of bus bars on the cell surface. All electrical values were determined directly from this curve automatically by the implemented software package. As a reference standard a calibrated solar cell from ISE Freiburg consisting of the same area dimensions, same wafer material and processed using the same front side layout is tested and the data compared to the certificated values. At least 5 wafers processed in the very same way are measured and the data interpreted by calculating the average of each value. The software PVCTControl 4.313.0 provides values for efficiency, fill factor, short circuit current, series resistance and open circuit voltage.

Example 7: solar cell based on PEDOT : PSS Example 2 in the absence of passivation layer between Silicon and PEDOT : PSS (inventive)

An n-Type substrate was subjected to RCA cleaning. Subsequent processing was analogue to Example 6.

Example 8: solar cell based on PEDOT : PSS Example 1 in the presence of a SiOx layer between Silicon and PEDOT : PSS (comparative)

An n-Type substrate was subjected to RCA cleaning. Subsequently the substrate was processed according to example 8. After the HF-cleaning the substrate was allowed to stand at room temperature for 30 h. PEDOT : PSS from Example 1 was deposited by spin-coating on the entire rear at 500 revolutions per minute (rpm) for 10 seconds and subsequently 1000 rpm for 30 seconds. The sample was then dried on a hotplate in air at 130°C for 15 min. PEDOT : PSS thickness is in the range between 50 and 200 nm. Finally, the entire rear surface was metalized by electron beam evaporated silver.

Table 3: determination of open circuit voltage ($V_{OC}$), short circuit current density ($J_{SC}$), Fill Factor (FF), efficiency (η), and sheet resistance ($R_{s_dlt}$) for p-type and n-type solar cells based on PEDOT : PSS of Example 1 and 2.

| Example | silicon typ | PEDOT: PSS | PEDOT: PSS deposition delay after HF | $V_o$ (mV) | $J_{sc}$ ($mA/cm^2$) | FF (%) | η (%) | $R_{s_dlt}$ ($\Omega cm^2$) |
|---|---|---|---|---|---|---|---|---|
| 6 | p | Example 2 | none | 657 | 38.9 | 80.6 | 20.6 | 0.5 |
| 7 | n | Example 2 | none | 654 | 36.7 | 75.1 | 18.0 | 0.8 |
| 8 | n | Example 1 | 30h | 653 | 39.7 | 67.2 | 17.4 | 2.9 |

Table 3 shows clearly the use of PEDOT : PSS of Example 2 leads to very high efficient devices with high fill factor. It also shows that the absence of an SiOx layer leads to improved fill factor and efficiency.

LIST OF REFERENCE NUMBERS

**[0115]**

| | |
|---|---|
| 1 | solar cell |
| 2 | substrate (i. e. n-type or p-type Si wafer, preferably n-doped c-Si) |
| 2' | $n^+$-region |
| 2a | front side |
| 2b | back side |
| 3 | passivation layer |
| 3' | $Al_2O_3$ layer or $SiO_2$ layer |
| 3" | $SiN_x$ layer |
| 4 | conductive polymer layer (preferably a PEDOT : PSS layer) |
| 5 | metal containing layer (first electrode) |
| 6 | metal containing layer (second electrode) |

## Claims

1. A solar cell (1) comprising a substrate (2) of p-type silicon or n-type silicon, wherein the substrate (2) comprises

   - a front side (2a) the surface of which is at least partially covered with at least one passivation layer (3) and
   - a back side (2b),

   wherein the back side (2b) of the substrate (2) is at least partially covered with a conductive polymer layer (4) and wherein at least one of the following conditions a) and b) is fulfilled:

   a) the conductive polymer layer (4) is at least partially in direct contact with the surface of the p-type or n-type silicon;
   b) the conductive polymer layer (4) comprises a cationic conductive polymer and a polymeric anion in a weight ratio cationic conductive polymer : polymeric anion of greater than 0.4, preferably greater than 0.5, more preferably greater than 0.6 and more preferably greater than 0.65.

2. The solar cell (1) according to claim 1, wherein the at least one passivation layer (3) is selected from the group consisting of a silicon nitride layer ($SiN_x$), a silicon oxide layer ($SiO_x$), a silicon carbide layer (SiC), a titanium oxide layer ($TiO_x$), an aluminium oxide layer ($AlO_x$), a layer of amorphous silicon (a-Si) or a layer stack comprising of an intrinsic undoped amorphous silicon layer (a-Si (i)) and Si n- or p-doped amorphous silicon layer (a-Si (n)) or a combination of at least two of these layers.

3. The solar cell (1) according to anyone of the preceding claims, wherein the surface on the front side (2a) of the substrate (2) has a texture with maxima and minima.

4. The solar cell (1) according to anyone of the proceeding claims, wherein the solar cell (1) comprises a first metal containing layer (6) being in an electrically conductive contact with the front side (2a) of the substrate (2) and a second metal containing layer (5) being in an electrically conductive contact with the conductive polymer layer (4) on the back side (2b) of the substrate (2).

5. The solar cells (1) according to claim 4, wherein the substrate (2) at the front side (2a) and beneath the at least one passivation layer (3) comprises an n-doped front surface field ($n^+$-FSF) (2').

6. The solar cells (1) according to claim 5, wherein the passivation layer (3) is a layer of n-doped amorphous silicon (a-Si (n)) or a layer stack comprising an intrinsic undoped amorphous silicon layer (a-Si (i)) and Si n-doped amorphous silicon layer (a-Si (n)) and wherein the passivation layer (3) is covered with a layer of a transparent conductive coating.

7. The solar cell (1) according to anyone of claims 4 to 6, wherein the first metal containing layer (6) being in an electrically conductive contact with the front side (2a) of the substrate (2) is applied in the form of a metal grid or in the form of a pattern comprising at least one metal busbar and metal fingers.

**8.** The solar cell according to anyone of claims 1 to 3, wherein the solar cell (1) comprises a first metal containing layer (6) being in an electrically conductive contact with the back side (2b) of the substrate (2) and a second metal containing layer (5) being in an electrically conductive contact with the conductive polymer layer (4) on the back side (2b) of the substrate (2).

**9.** The solar cell (1) according to anyone of the preceding claims, wherein the conductive polymer layer (4) comprises a cationic polythiophene as the cationic conductive polymer and a polymeric sulfonic acid or a polymeric carboxylic acid as the polymeric anion.

**10.** The solar cell (1) according to claim 9, wherein in the conductive polymer layer (4) the cationic polythiophene and the polymeric anion are present in the form of a polythiophene : polymeric anion-complex, preferably a PEDOT : PSS-complex.

**11.** A process for the preperation of a solar cell (1) comprising the process steps:

I) providing a substrate (2) of p-type silicon or n-type silicon, wherein the substrate (2) comprises

- a front side (2a)
and
- a back side (2b);

II) treatment of the back side (2b) with an etching agent;
III) covering at least a part of the treated surface on the back side (2b) of the substrate with a layer of a conductive polymer (4), wherein at least one of the following conditions A) and B) is fulfilled:

A) in process step III) the treated surface on the back side (2b) of the substrate is brought into contact with the layer of a conductive polymer (4) in such a way that the conductive polymer layer (4) is at least partially in direct contact with the surface of the p-type or n-type silicon;
B) the conductive polymer layer (4) comprises a cationic conductive polymer and a polymeric anion in a weight ratio cationic conductive polymer : polymeric anion of greater than 0.4, preferably greater than 0.5, more preferably greater than 0.6 and more preferably greater than 0.65;

IV) optionally covering at least a part of the surface of the conductive polymer layer (4) with a metal containing layer (5).

**12.** The process according to claim 11, wherein the etching agent is an aqueous solution of at least one mineral acid, preferably an aqueous solution of HF, or an aqueous solution of a mixture of HF and at least one further mineral acid selected from the group consisting of $H_2SO_4$, $H_3PO_4$, HBr, HI, $HClO_4$ and $HIO_4$, particularly preferably an aqueous hydrofluoric acid solution having a concentration the range from 0.1 to 5 wt.-%.

**13.** The process according to claim 11 or 12, wherein the conductive polymer layer (4) is formed by applying a liquid composition comprising the cationic conductive polymer, the polymeric anion and a solvent onto the back side (2b) and by subsequently removing at least a part of the solvent.

**14.** The process according to claim 13, wherein the liquid composition comprises a cationic polythiophene as the cationic conductive polymer and a polymeric sulfonic acid or a polymeric carboxylic acid as the polymeric anion.

**15.** The process according to claim 14, wherein in the liquid composition the cationic polythiophene and the polymeric anion are present in the form of a polythiophene : polymeric anion-complex, preferably a PEDOT : PSS-complex.

**16.** The process according to anyone of claims 11 to 15, wherein the substrate (2) is based on n-type monocrystalline silicon (c-Si).

**17.** The process according to anyone of claims 11 to 16, wherein the surface on the front side (2a) of the substrate (2) is at least partially covered with at least one passivation layer (3) selected from the group consisting of a silicon nitride layer ($SiN_x$), a silicon oxide layer ($SiO_x$), a silicon carbide layer (SiC), a titanium oxide layer ($TiO_x$), an aluminium oxide layer ($AlO_x$), a layer of amorphous silicon (a-Si) or a layer stack comprising of an intrinsic undoped amorphous silicon layer (a-Si (i)) and Si n- or p-doped amorphous silicon layer (a-Si (n)) or a combination of at least

two of these layers.

**18.** The process according to anyone of claims 11 to 17, wherein the surface on the front side (2a) of the substrate (2) has a texture with maxima and minima.

**19.** Solar cell (1), obtainable by the process according to anyone of claims 11 to 18.

**20.** A solar module, comprising at least one solar cell (1) according to anyone of claims 1 to 10 and 19 and at least one further solar cell.

Fig. 1

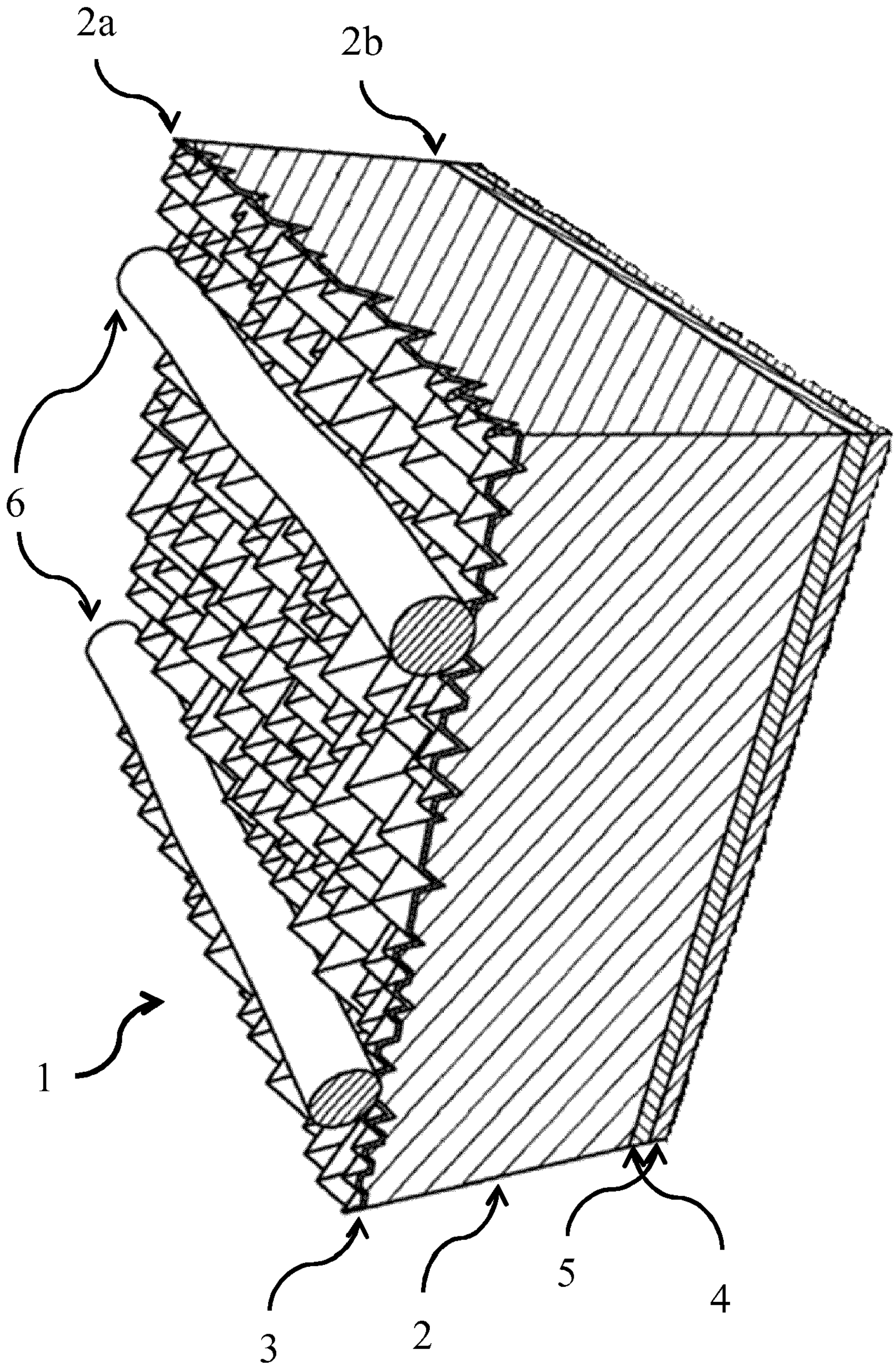

Fig. 2

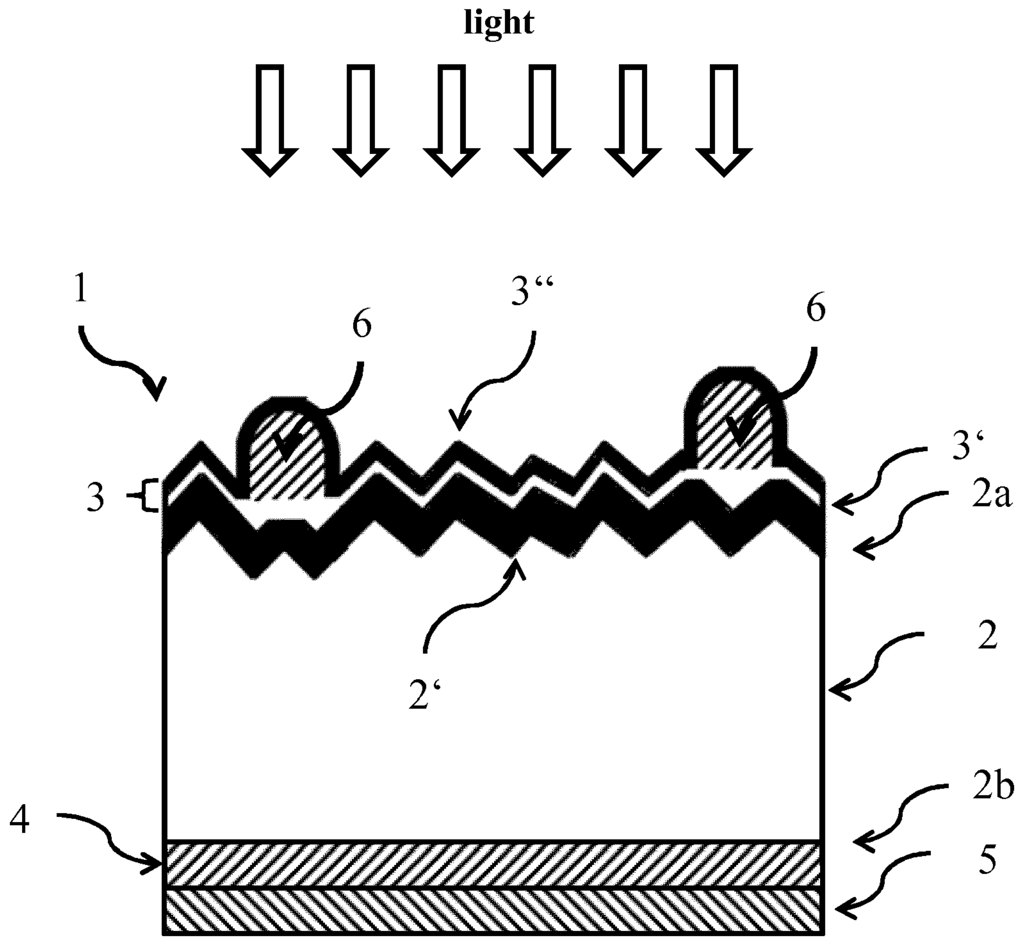

Fig. 3

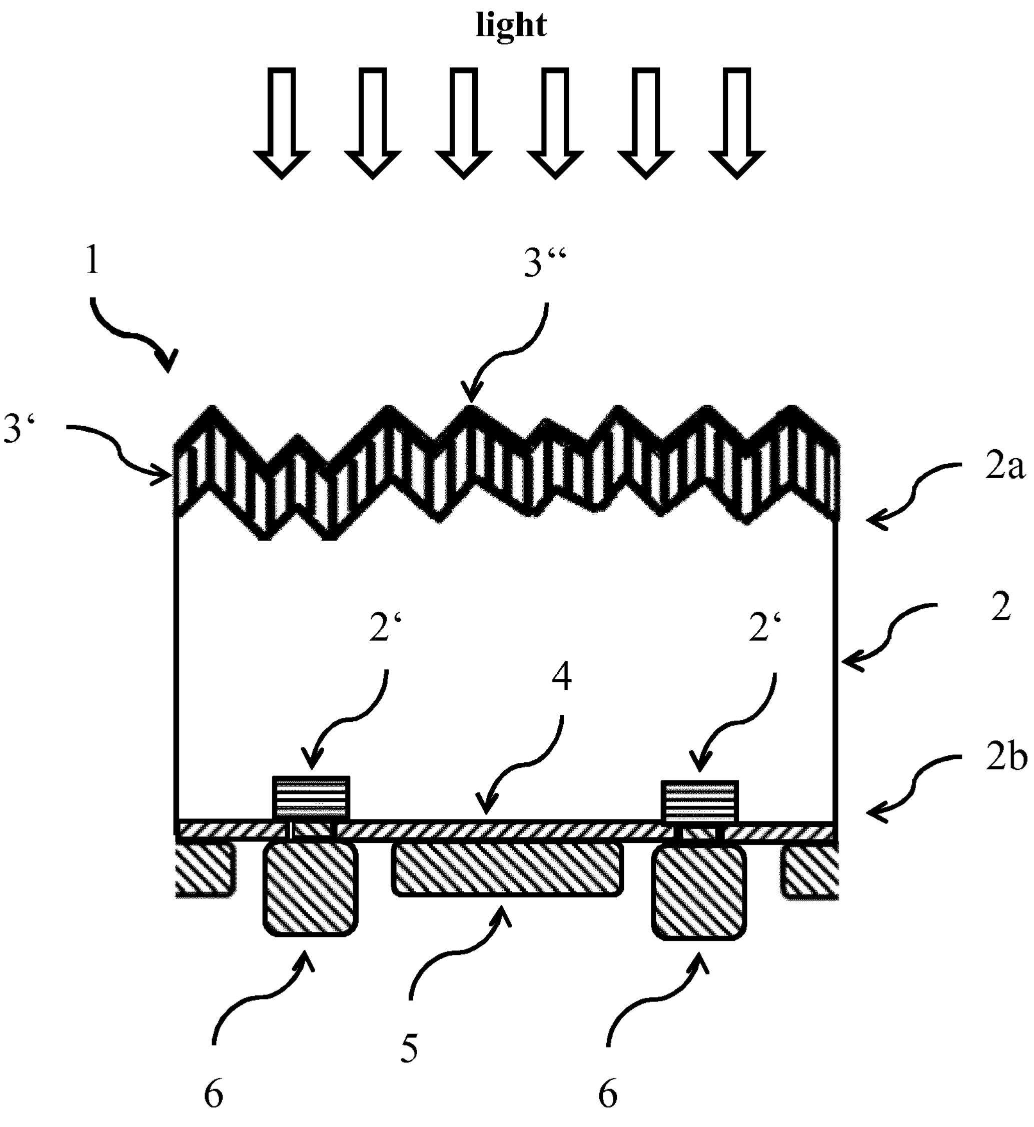

Europäisches Patentamt
European Patent Office
Office européen des brevets

# EUROPEAN SEARCH REPORT

Application Number
EP 15 15 8258

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZIELKE DIMITRI ET AL: "Organic-silicon heterojunction solar cells onn-type silicon wafers: The BackPEDOT concept", SOLAR ENERGY MATERIALS AND SOLAR CELLS, ELSEVIER SCIENCE PUBLISHERS, AMSTERDAM, NL, vol. 131, 7 June 2014 (2014-06-07), pages 110-116, XP029075015, ISSN: 0927-0248, DOI: 10.1016/J.SOLMAT.2014.05.022 | 1-7,9-20 | INV. H01L51/42 H01L31/0224 H01L51/46 |
| A | * page 111; figure 1 * * page 113 - page 114; figure 2 * * abstract * | 8 | |
| X | JUNGHANNS MARCUS ET AL: "PEDOT:PSS emitters on multicrystalline silicon thin-film absorbers for hybrid solar cells", APPLIED PHYSICS LETTERS, AMERICAN INSTITUTE OF PHYSICS, US, vol. 106, no. 8, 25 February 2015 (2015-02-25), XP012194894, ISSN: 0003-6951, DOI: 10.1063/1.4913869 [retrieved on 1901-01-01] | 1-3,8-20 | TECHNICAL FIELDS SEARCHED (IPC) |
| A | * pages 083904-1 - pages 083904-2; figure 1 * * abstract * | 4-7 | H01L |
| X | US 2011/030782 A1 (OH MIN-SEOK [KR]) 10 February 2011 (2011-02-10) | 1-3,8-20 | |
| A | * paragraph [0038] - paragraph [0083]; claims 1-26; figures 1-5 * | 4-7 | |

The present search report has been drawn up for all claims

1

| Place of search | Date of completion of the search | Examiner |
|---|---|---|
| The Hague | 25 August 2015 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 15 15 8258

This annex lists the patent family members relating to the patent documents cited in the above-mentioned European search report. The members are as contained in the European Patent Office EDP file on
The European Patent Office is in no way liable for these particulars which are merely given for the purpose of information.

25-08-2015

| Patent document cited in search report | Publication date | Patent family member(s) | Publication date |
|---|---|---|---|
| US 2011030782 A1 | 10-02-2011 | KR 20110015999 A | 17-02-2011 |
| | | US 2011030782 A1 | 10-02-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20040259335 A1
- US 20130025663 A1
- WO 2012025511 A1
- US 20070209699 A1
- EP 844650 A2
- EP 0156366 A2


### Non-patent literature cited in the description


- **SCHMIDT et al.** Organic-silicon heterojunction solar cells: Open-circuit voltage potential and stability. *Appl. Phys. Lett.,* 2013, vol. 103, 183901
- **HOUBEN WEYL.** Methoden der organischen Chemie. *Makromolekulare Stoffe,* 1987, vol. E 20, 1141
- **KIRCHMEYER et al.** *the Journal of Materials Chemistry,* 2005, vol. 15 (21), 2077-2088
- **J.C.C. TSAI.** Shallow Phosphorous Diffusion Profiles in Silicon. *Proc. of the IEEE,* 1969, vol. 57 (9), 1499-1506
- **MEIER et al.** N-Type, ion Implanted silicon solar cells and modules. *Proc. 37 PVSC,* 3337
- **D. ZIELKE et al.** Contact passivation in silicon solar cells using atomic-layer-deposited aluminum oxide layers. *Phys. Stat. Sol. RRL,* 2011, vol. 5, 298-300